# EUROPÄISCHE PATENTSCHRIFT

(11) **EP 4 505 255 B1**
(45) Veröffentlichungstag und Bekanntmachung des Hinweises auf die Patenterteilung: **01.07.2026**
(21) Anmeldenummer: 23715114.7
(22) Anmeldetag: 28.03.2023
(51) Int. Cl.: G05B 19/042, G05B 23/02

(54) **VERFAHREN ZUR ÜBERPRÜFUNG MINDESTENS EINES ERSTEN TAKTGEBERS EINES ERSTEN FELDGERÄTS IN EINEM PROZESSMESSSYSTEM**
METHOD FOR CHECKING AT LEAST ONE FIRST CLOCK GENERATOR OF A FIRST FIELD DEVICE IN A PROCESS MEASURING SYSTEM
PROCÉDÉ DE VÉRIFICATION D'AU MOINS UN PREMIER GÉNÉRATEUR D'HORLOGE D'UN PREMIER DISPOSITIF DE TERRAIN DANS UN SYSTÈME DE MESURE DE PROCESSUS

(30) Priorität: 06.04.2022 DE 102022108316
(43) Veröffentlichungstag der Anmeldung: 12.02.2025
(60) Teilanmeldung: 25158285.4
(73) Patentinhaber: Endress+Hauser SE+Co. KG, 79689 Maulburg (DE)
(72) Erfinder: VOGEL, Alexander, 79199 Kirchzarten (DE); MALINOVSKIY, Alexey, 79689 Maulburg (DE); KARWECK, Lars, 79589 Binzen (DE); D'ANGELICO, Sascha, 79595 Rümmingen (DE); FREY, Volker, 79650 Schopfheim (DE); HAAG, Tanja, 79650 Schopfheim (DE); SCHMITT, Christoph, 79650 Schopfheim (DE); SCHÖNBORN, Nicolas, 33397 Rietberg (DE)
(74) Vertreter: Endress + Hauser Group Services (Deutschland) AG+Co. KG
(86) Internationale Anmeldenummer: PCT/EP2023/057902
(87) Internationale Veröffentlichungsnummer: WO 2023/194143

(56) Entgegenhaltungen:
- WO-A1-2009/062535
- DE-A1- 102016 117 007
- DE-A1- 102016 222 618

## Beschreibung

Die Erfindung betrifft ein Verfahren zur Überprüfung mindestens eines ersten Taktgebers eines ersten Feldgeräts in einem Prozessmesssystem, wobei das Prozessmesssystem das erste Feldgerät und mindestens zwei weitere Feldgeräte mit jeweils mindestens einem Taktgeber umfasst, wobei jedes Feldgerät mindestens einen chemischen und/oder physikalischen Parameter eines Mediums bestimmt und/oder überwacht, wobei für jeden Taktgeber eine Soll-Frequenz vorgegeben ist und jeder Taktgeber eine Ist-Frequenz erzeugt, wobei das erste Feldgerät dazu ausgestaltet ist, Informationen mit den mindestens zwei weiteren Feldgeräten auszutauschen.

In der Automatisierungstechnik, insbesondere in der Prozessautomatisierungstechnik werden vielfach Feldgeräte eingesetzt, die zur Erfassung und/oder Beeinflussung von Prozessvariablen dienen. Zur Erfassung von Prozessvariablen dienen Sensoren, wie beispielsweise Füllstandsmessgeräte, Durchflussmessgeräte, Druck- und Temperaturmessgeräte, pH- und Redoxpotentialmessgeräte, Leitfähigkeitsmessgeräte, usw., welche die entsprechenden Prozessvariablen Füllstand, Durchfluss, Druck, Dichte, Temperatur, pH-Wert bzw. Leitfähigkeit erfassen. Zur Beeinflussung von Prozessvariablen dienen Aktoren, wie zum Beispiel Ventile oder Pumpen, über die der Durchfluss einer Flüssigkeit in einem Rohrleitungsabschnitt bzw. der Füllstand in einem Behälter geändert werden kann. Als Feldgeräte werden alle Geräte bezeichnet, die prozessnah eingesetzt werden und die prozessrelevante Informationen liefern oder verarbeiten. Im Zusammenhang mit der Erfindung werden unter Feldgeräten also insbesondere auch Remote I/Os, Speisegeräte, Funkadapter bzw. allgemein Geräte verstanden, die auf der Feldebene angeordnet sind.

Ein Feldgerät umfasst typischerweise einen zumindest teilweise und/oder zumindest zeitweise mit dem Prozess in Berührung kommenden Sensor und eine Elektronikeinheit, welche beispielsweise der Signalerfassung, Signalauswertung und/oder Signalspeisung dient. Die Elektronikeinheit des Feldgeräts ist typischerweise in einem Gehäuse angeordnet und verfügt zusätzlich über mindestens ein Anschlusselement zum Anschluss der Elektronikeinheit an den Sensor und/oder eine externe Einheit. Das Anschlusselement kann eine beliebige Verbindung sein, auch eine drahtlose Verbindung ist einsetzbar. Die Elektronikeinheit und der Sensor des Feldgeräts können in Form separater Einheiten mit getrennten Gehäusen oder als eine gemeinsame Einheit mit einem Gehäuse ausgestaltet sein.

Feldgeräte können mit einem oder mehreren Taktgebern ausgestattet sein, welche einen Takt in Form einer Frequenz ausgeben. Der Taktgeber weist in der Regel einen Schwingquarz in Form eines Quarzoszillators auf, welcher sich durch eine besonders hohe Genauigkeit auszeichnet, aber auch andere Taktgeber können prinzipiell eingesetzt werden. Der durch den Taktgeber ausgegebene Takt kann zur zeitlichen Synchronisation von Aktionen mehrerer Schaltkreise eingesetzt werden und spielt daher insbesondere bei solchen Feldgeräten eine Rolle, bei denen die Zeit oder eine Zeitdauer für die Bestimmung des mindestens einen chemischen und/oder physikalischen Parameters eines Mediums eine relevante Einflussgröße ist. Derartige Feldgeräte sind beispielsweise Laufzeitmessgeräte, welche mittels der Aussendung von beispielsweise Radarwellen oder Ultraschallwellen einen Füllstand oder einen Durchfluss eines Mediums bestimmen, sowie Dichtemessgeräte. Die Genauigkeit des vom Taktgebers vorgegebenen Takts wirkt sich bei derartigen Feldgeräten unmittelbar auf die Genauigkeit des bestimmten Parameters des Mediums aus.

Um einen Taktgeber des Feldgeräts zu überprüfen oder zu kalibrieren, werden diese bisher in regelmäßigen Abständen durch externe Referenz-Taktgeber kontrolliert, wofür das Feldgerät von seiner Messstelle entfernt werden muss. Alternativ werden redundante Taktgeber als Referenz-Taktgeber im Feldgerät verbaut, welche einen zusätzlichen Bedarf an Schaltungen, Platz und Energie mit sich bringen.

In der DE 10 2016 117 007 A1 ist ein Verfahren zur Verifikation eines Taktgebers eines Feldgeräts, das einen chemischen oder physikalischen Parameter überwacht, offenbart.

Die Aufgabe der vorliegenden Erfindung ist es daher, ein Verfahren anzugeben, bei welchem ein Taktgeber auf einfache Weise überprüft werden kann.

Die Aufgabe wird erfindungsgemäß gelöst durch ein Verfahren zur Überprüfung mindestens eines ersten Taktgebers eines ersten Feldgeräts in einem Prozessmesssystem, wobei das Prozessmesssystem das erste Feldgerät und mindestens zwei weitere Feldgeräte mit jeweils mindestens einem Taktgeber umfasst, wobei jedes Feldgerät mindestens einen chemischen und/oder physikalischen Parameter eines Mediums bestimmt und/oder überwacht, wobei für jeden Taktgeber eine Soll-Frequenz vorgegeben ist und jeder Taktgeber eine Ist-Frequenz erzeugt, wobei das erste Feldgerät eine Recheneinheit aufweist und dazu ausgestaltet ist, Informationen mit den mindestens zwei weiteren Feldgeräten auszutauschen, wobei das Verfahren zumindest die folgenden Schritte vorsieht:
- Erzeugen einer Ist-Frequenz des mindestens ersten Taktgebers,
- Übermitteln der erzeugten Ist-Frequenz und der Soll-Frequenz des mindestens ersten Taktgebers an die mindestens zwei weiteren Feldgeräte,
- Ermitteln einer Abweichung der erzeugten Ist-Frequenz von der Soll-Frequenz des mindestens ersten Taktgebers mittels des jeweiligen Taktgebers der mindestens zwei weiteren Feldgeräte,
- Übermitteln der ermittelten Abweichungen an das erste Feldgerät,
- Vergleichen der ermittelten Abweichungen und/oder eines Durchschnittswerts der ermittelten Abweichungen mit einem vorgegebenen Toleranzbereich der Soll-Frequenz des mindestens ersten Taktgebers mittels der Recheneinheit,
- Ausgeben mindestens einer Zustandsinformation über den mindestens ersten Taktgeber anhand des Vergleichs mittels der Recheneinheit.

Mittels des erfindungsgemäßen Verfahrens wird der mindestens erste Taktgebers des ersten Feldgeräts auf einfache Weise mithilfe weiterer mit mindestens einem Taktgeber ausgestattete Feldgeräte vor Ort überprüft. Ein Ausbau des ersten Feldgerät ist dabei nicht nötig, sondern das Verfahren kann innerhalb des Prozessmesssystems durchgeführt werden. Dem mindestens ersten Taktgeber ist dabei ein vorgegebener Toleranzbereich der Soll-Frequenz zugeordnet. Solange die Ist-Frequenz des mindestens ersten Taktgebers innerhalb des vorgegebenen Toleranzbereichs der Soll-Frequenz des mindestens ersten Taktgebers liegt, ist eine gewünschte Genauigkeit des mindestens ersten Taktgebers gegeben. Allerdings kann sich die Genauigkeit des ersten Taktgebers mit der Zeit verschlechtern, so dass der erste Taktgeber eine Ist-Frequenz ausgeben kann, welche von seiner Soll-Frequenz abweicht. Bei einer Überschreitung des vorgegebenen Toleranzbereichs der Soll-Frequenz durch die Ist-Frequenz ist die Genauigkeit des mindestens ersten Taktgebers beeinträchtigt.

Zur Überprüfung des mindestens ersten Taktgebers werden mindestens zwei weitere Feldgeräte eingesetzt. Die mindestens zwei Taktgeber der mindestens zwei weiteren Feldgeräte weisen ebenfalls eine Ist-Frequenz und eine Soll-Frequenz auf und nutzen insbesondere ihre Ist-Frequenz, um die Ist-Frequenz des mindestens ersten Taktgebers mit der Soll-Frequenz des mindestens ersten Taktgebers zu vergleichen. Die dabei ermittelten Abweichungen werden anschließend mit dem vorgegebenen Toleranzbereich der Soll-Frequenz des mindestens ersten Taktgebers verglichen. Alternativ kann ein Durchschnittswert aus den ermittelten Abweichungen gebildet werden und dieser mit dem vorgegebenen Toleranzbereich der Soll-Frequenz des mindestens ersten Taktgebers verglichen werden. Anhand dieses Vergleichs wird schließlich mindestens eine Zustandsinformation über den mindestens ersten Taktgeber ausgegeben.

Die mindestens zwei Taktgeber der mindestens zwei weiteren Feldgeräte können ebenfalls eine Abweichung der Ist-Frequenz von der ihnen vorgegebenen Soll-Frequenz aufweisen. Das erfindungsgemäße Verfahren wird daher umso präziser, je mehr weitere Feldgeräte zur Überprüfung des ersten Taktgebers eingesetzt werden. Um mögliche Abweichungen der mindestens zwei weiteren Taktgeber zu berücksichtigen, bietet es sich insbesondere an einen Durchschnittswert aus den ermittelten Abweichungen zu bilden und diesen mit dem vorgegebenen Toleranzbereich der Soll-Frequenz des mindestens ersten Taktgebers zu vergleichen.

In einer Ausgestaltung wird als mindestens eine Zustandsinformation über den mindestens ersten Taktgeber eine Warnung ausgegeben, wenn die ermittelten Abweichungen und/oder der Durchschnittswert der ermittelten Abweichungen außerhalb des vorgegebenen Toleranzbereichs der Soll-Frequenz liegen. Anhand der Warnung kann beispielsweise ein Bediener erkennen, dass ein Fehler des mindestens ersten Taktgebers vorliegt und ggf. Gegenmaßnahmen, wie eine Kalibration oder eine Wartung, einleiten.

In einer weiteren Ausgestaltung wird als mindestens eine Zustandsinformation über den mindestens ersten Taktgeber ein Korrekturfaktor ausgegeben, wobei der Korrekturfaktor angibt, in welchem Maß der mindestens erste Taktgeber von dem vorgegebenen Toleranzbereich abweicht. Anhand des Korrekturfaktors kann erkannt werden, inwieweit oder wie sehr die Ist-Frequenz des mindestens ersten Taktgebers von dem vorgegebenen Toleranzbereich der Soll-Frequenz des mindestens ersten Taktgebers abweicht.

In einer weiteren Ausgestaltung wird als mindestens eine Zustandsinformation über den mindestens ersten Taktgeber eine Restfunktionsdauer des mindestens ersten Taktgebers ausgegeben, nach deren Ablauf die ermittelten Abweichungen und/oder der Durchschnittswert der ermittelten Abweichungen außerhalb des vorgegebenen Toleranzbereichs liegen werden. Auf diese Weise lässt sich ermitteln oder zumindest abschätzen, wie lange noch der mindestens erste Taktgeber eine Ist-Frequenz erzeugt, welche innerhalb des vorgegebenen Toleranzbereichs der Soll-Frequenz liegt. Anhand der Restfunktionsdauer kann beispielsweise in vorausschauender Weise eine Wartung oder Kalibration des mindestens ersten Taktgebers geplant werden.

In einer Weiterbildung wird die Ist-Frequenz des mindestens ersten Taktgebers mithilfe der ermittelten Abweichungen und/oder dem Durchschnittswert der ermittelten Abweichungen und/oder dem Korrekturfaktor auf die Soll-Frequenz korrigiert. Die Korrektur der Ist-Frequenz des mindestens ersten Taktgebers kann beispielsweise durchgeführt werden, während das erste Feldgerät an seiner Messstelle im Prozessmesssystem angebracht ist. Alternativ kann das Feldgerät von seiner Messstelle für die Korrektur entfernt werden. Die Korrektur der Ist-Frequenz des mindestens ersten Taktgebers kann insbesondere mittels einer im ersten Feldgerät vorhandenen Software oder einer im ersten Feldgerät vorhandenen Hardware durchgeführt werden.

Eine Ausgestaltung sieht vor, dass das erste Feldgerät zumindest mittels des mindestens ersten Taktgebers mindestens einen chemischen und/oder physikalischen Parameter des Mediums bestimmt und/oder überwacht. Die Genauigkeit des mindestens ersten Taktgebers wirkt sich somit unmittelbar auf die Genauigkeit des bestimmten und/oder überwachten Parameters aus.

Bevorzugterweise wird jede ermittelte Abweichung in Abhängigkeit von dem Feldgerät, durch welches sie ermittelt wurde, gewichtet. Die mindestens zwei Taktgeber der mindestens zwei Feldgeräte, welche jeweils eine Abweichung ermitteln, können analog zum mindestens ersten Taktgeber im Laufe der Zeit eine Ist-Frequenz erzeugen, welche von ihrer Soll-Frequenz abweicht. Um eine ggf. vorhandene jeweilige Abweichung der Ist-Frequenz von der Soll-Frequenz der mindestens zwei Taktgeber der mindestens zwei weiteren Feldgeräte zu berücksichtigen, werden die ermittelten Abweichungen mit einer Gewichtung versehen, wobei jede Abweichung separat je nach Feldgerät, durch welche sie ermittelt wurde, gewichtet wird.

Insbesondere wird jede ermittelte Abweichung in Abhängigkeit von einer Zustandsinformation des Feldgeräts, durch welches sie ermittelt wurde, gewichtet.

Vorteilhafterweise wird als Zustandsinformation des Feldgeräts ein Zeitraum seit der letzten Kalibration des Taktgebers des jeweiligen Feldgeräts und/oder das Vorliegen eines Fehlers und/oder eines Wartungsbedarfs des Feldgeräts und/oder eine Genauigkeitsklasse des mindestens einen Taktgebers des Feldgeräts verwendet. Ist beispielsweise als Zustandsinformation des Feldgeräts bekannt, dass ein Fehler des Feldgeräts vorliegt oder dass das Feldgerät einen Wartungsbedarf hat, so ist die durch das Feldgerät ermittelte Abweichung wahrscheinlich ungenauer als in den umgekehrten Fällen, wenn das Feldgerät voll funktionstüchtig und frei von Wartungsbedarfen ist. Entsprechend kann eine ermittelte Abweichung, welche durch ein Feldgerät mit einem vorliegenden Fehler oder einem Wartungsbedarf ermittelt wurde, niedriger gewichtet sein als bei einem fehler- oder wartungsfreien Feldgerät. Auch kann angenommen werden, dass mit einer zunehmenden Länge des Zeitraums seit der letzten Kalibration des Taktgebers die durch den Taktgeber bzw. Feldgerät ermittelte Abweichung ungenauer wird. Dementsprechend können Abweichungen, welche durch Feldgeräte mit einem kürzeren Zeitraum seit der letzten Kalibration ihres Taktgebers ermittelt wurden, stärker gewichtet werden als solche Abweichungen, welche durch Feldgeräte mit einem längeren Zeitraum seit der letzten Kalibration ihres Taktgebers ermittelt wurden. Weniger stark gewichtete ermittelte Abweichungen haben einen geringeren Einfluss auf den Vergleich zwischen den ermittelten Abweichungen und/oder eines Durchschnittswerts der ermittelten Abweichungen mit einem vorgegebenen Toleranzbereich der Soll-Frequenz des mindestens ersten Taktgebers.

In einer weiteren Ausgestaltung wird als das erste Feldgerät ein Dichtemessgerät, ein Durchflussmessgerät oder ein Laufzeit-Füllstandsmessgerät verwendet. Ein Laufzeit-Füllstandsmessgerät bestimmt und/oder überwacht den Füllstand eines Mediums, beispielsweise mithilfe von Ultraschallwellen oder Radar. Eine präzise Messung der Laufzeit setzt einen genauen Taktgeber bzw. genaue Taktgeber des ersten Feldgeräts voraus. Auch Durchflussmessgeräte sind auf eine genaue Messung der Zeit angewiesen. Dies gilt insbesondere bei Durchflussmessgeräten, welche Laufzeittechniken zur Bestimmung des Durchflusses einsetzen, aber auch z.B. für Coriolis-Durchflussmessgeräte oder Vortex-Durchflussmessgeräte, da bei diesen Durchflussmessgeräten der Durchfluss anhand von Frequenzen bestimmt wird, welcher somit auf eine genaue Zeit- bzw. Frequenzmessung angewiesen ist. Dichtemessgeräte wiederum bestimmen die Dichte eines Mediums. Als Dichtemessgeräte werden beispielsweise Biegeschwinger oder Schwinggabeln eingesetzt, welche die Dichte eines Mediums anhand einer Änderung ihrer Resonanzfrequenz bestimmen. Zur genauen Frequenzbestimmung ist ebenso ein präziser Taktgeber nötig.

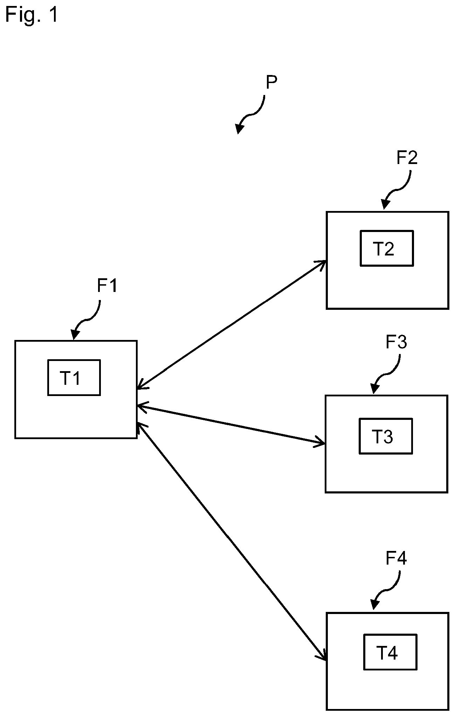

Die Erfindung wird anhand der nachfolgenden Figur Fig. 1 näher erläutert werden. Sie zeigt:
Fig. 1: eine schematische Darstellung eines Prozessmesssystems.

Das Prozessmesssystem P umfasst das erste Feldgerät F1 mit mindestens einem ersten Taktgeber T1 und mindestens zwei weitere Feldgeräte F2, F3 mit jeweils mindestens einem Taktgeber T2, T3. In Fig. 1 sind beispielhaft drei weitere Feldgeräte F2, F3, F4 dargestellt. Je mehr weitere Feldgeräte F2, F3, F4 im erfindungsgemäßen Verfahren eingesetzt werden, umso genauer kann der mindestens erste Taktgeber T1 überprüft werden. Jedes der Feldgeräte F1, F2, F3, F4 bestimmt und/oder überwacht mindestens einen chemischen und/oder physikalischen Parameter eines Mediums. Eine nicht-beschränkende Auswahl an Feldgeräten wurde einleitend angegeben. Das erfindungsgemäße Verfahren ist insbesondere für erste Feldgeräte F1 vorteilhaft, welche zumindest mittels des mindestens ersten Taktgebers T1 mindestens einen chemischen und/oder physikalischen Parameter des Mediums bestimmen und/oder überwachen. Das erste Feldgerät F1 kann beispielsweise ein Dichtemessgerät, ein Durchflussmessgerät oder ein Laufzeit-Füllstandsmessgerät sein.

Jeder Taktgeber T1, T2, T3, T4 erzeugt eine Ist-Frequenz und weist eine vorgegebene Soll-Frequenz auf. Das erste Feldgerät F1 ist dazu ausgestaltet, Informationen mit den mindestens zwei weiteren Feldgeräten auszutauschen. Dafür weisen die mindestens drei Feldgeräte F1, F2, F3, F4 beispielsweise entsprechend ausgestaltete Übertragungseinheiten (nicht gezeigt) auf. Die Doppelpfeile im Fig. 1 deuten den Informationsaustausch zwischen den jeweiligen Feldgeräten an.

In einem ersten Schritt des ersten erfindungsgemäßen Verfahrens wird eine erzeugte Ist-Frequenz und die vorgegebene Soll-Frequenz des ersten Taktgebers T1 an die mindestens zwei weiteren Feldgeräte F2, F3 übermittelt. Anschließend wird eine Abweichung der Ist-Frequenz von der Soll-Frequenz des mindestens ersten Taktgebers T1 mittels des jeweiligen Taktgebers T2, T3 der mindestens zwei weiteren Feldgeräte F2, F3 ermittelt. Die ermittelten Abweichungen werden dann an das erste Feldgerät F1 übermittelt. In einem nächsten Schritt werden die ermittelten Abweichungen und/oder ein Durchschnittswert der ermittelten Abweichungen mit einem vorgegebenen Toleranzbereich des Soll-Frequenz des mindestens ersten Taktgebers T1 verglichen und schließlich wird mindestens eine Zustandsinformation über den mindestens ersten Taktgeber T1 anhand des Vergleichs ausgegeben. Erfindungsgemäß weist das erste Feldgerät F1 eine Recheneinheit (nicht gezeigt) auf welche dazu ausgestaltet ist, den Vergleich durchzuführen und anhand des Vergleichs die mindestens eine Zustandsinformation über den mindestens ersten Taktgeber T1 auszugeben. Der vorgegebene Toleranzbereich des mindestens ersten Taktgebers T1 ist beispielsweise eine Genauigkeitsklasse des ersten Taktgebers T1.

Weiterhin ist es optional möglich, jede ermittelte Abweichung zu gewichten, beispielsweise in Abhängigkeit von dem Feldgerät F2, F3, durch welches sie ermittelt wurde oder in Abhängigkeit von einer Zustandsinformation desjenigen Feldgeräts F2, F3, durch welche sie ermittelt wurde. Als Zustandsinformation des Feldgeräts F2, F3 wird beispielsweise ein Zeitraum seit der letzten Kalibration des Taktgebers des jeweiligen Feldgeräts und/oder das Vorliegen eines Fehlers und/oder eines Wartungsbedarfs des Feldgeräts verwendet. Auf diese Weise können Ungenauigkeiten der in den mindestens zwei weiteren Feldgeräten F2, F3 vorliegenden Taktgeber T2, T3 im Verfahrensschritt des Vergleichs optional berücksichtigt werden.

Als mindestens eine Zustandsinformation über den ersten Taktgeber T1 kann eine Warnung ausgegeben werden, wenn die ermittelten Abweichungen und/oder der Durchschnittswert der ermittelten Abweichungen außerhalb des vorgegebenen Toleranzbereichs der Soll-Frequenz liegen. Zusätzlich oder alternativ kann als mindestens eine Zustandsinformation über den mindestens ersten Taktgeber T1 ein Korrekturfaktor ausgegeben werden, welcher angibt, in welchem Maß der mindestens erste Taktgeber T1 von dem vorgegebenen Toleranzbereich abweicht. Zudem kann als mindestens eine Zustandsinformation über den mindestens ersten Taktgeber T1 eine Restfunktionsdauer des mindestens ersten Taktgebers T1 ausgegeben werden, nach deren Ablauf die ermittelten Abweichungen und/oder der Durchschnittswert der ermittelten Abweichungen außerhalb des vorgegebenen Toleranzbereichs liegen werden.

Weiterhin kann die Ist-Frequenz des mindestens ersten Taktgebers T1 mithilfe der ermittelten Abweichungen und/oder dem Durchschnittswert der ermittelten Abweichungen und/oder dem Korrekturfaktor auf die Soll-Frequenz korrigiert werden.

Im ersten Schritt weiteren, jedoch nicht beanspruchten, Verfahrens wird eine Ist-Frequenz des mindestens ersten Taktgebers T1 erzeugt, welche anschließend an die mindestens zwei weiteren Feldgeräte F2, F3 übermittelt wird. Im nächsten Schritt überprüfen die mindestens zwei weiteren Feldgeräte F2, F3 die Ist-Frequenz des mindestens ersten Taktgebers T1 mittels ihrer jeweiligen Taktgeber. Als Ergebnis dieser Überprüfung wird jeweils eine Referenz-Frequenz des mindestens ersten Taktgebers T1 bestimmt, welche anschließend an das erste Feldgerät F1 übermittelt wird. Im Folgenden wird jeweils eine Abweichung der Referenz-Frequenzen von der Soll-Frequenz des mindestens ersten Taktgebers T1 ermittelt. Danach werden die ermittelten Abweichungen und/oder ein Durchschnittswert der ermittelten Abweichungen mit einem vorgegebenen Toleranzbereich der Soll-Frequenz des mindestens ersten Taktgebers T1 verglichen und schließlich mindestens eine Zustandsinformation über den ersten Taktgeber T1 anhand des Vergleichs ausgegeben.

### Bezugszeichenliste

- Fn: n-tes Feldgerät
- Tn: n-ter Taktgeber
- P: Prozessmesssystem

## Patentansprüche

1. Verfahren zur Überprüfung mindestens eines ersten Taktgebers (T1) eines ersten Feldgeräts (F1) in einem Prozessmesssystem (P), wobei das Prozessmesssystem (P) das erste Feldgerät (F1) und mindestens zwei weitere Feldgeräte (F2, F3) mit jeweils mindestens einem Taktgeber (T2, T3) umfasst, wobei jedes Feldgerät (F1, F2, F3) mindestens einen chemischen und/oder physikalischen Parameter eines Mediums bestimmt und/oder überwacht, wobei für jeden Taktgeber (T1, T2, T3) eine Soll-Frequenz vorgegeben ist und jeder Taktgeber (T1, T2, T3) eine Ist-Frequenz erzeugt, wobei das erste Feldgerät (F1) eine Recheneinheit aufweist und dazu ausgestaltet ist, Informationen mit den mindestens zwei weiteren Feldgeräten (F2, F3) auszutauschen, wobei das Verfahren zumindest die folgenden Schritte vorsieht:
- Erzeugen einer Ist-Frequenz des mindestens ersten Taktgebers (T1),
- Übermitteln der erzeugten Ist-Frequenz und der Soll-Frequenz des mindestens ersten Taktgebers (T1) an die mindestens zwei weiteren Feldgeräte (F2, F3),
- Ermitteln einer Abweichung der erzeugten Ist-Frequenz von der Soll-Frequenz des mindestens ersten Taktgebers (T1) mittels des jeweiligen Taktgebers (T2, T3) der mindestens zwei weiteren Feldgeräte (F2, F3),
- Übermitteln der ermittelten Abweichungen an das erste Feldgerät (F1),
- Vergleichen der ermittelten Abweichungen und/oder eines Durchschnittswerts der ermittelten Abweichungen mit einem vorgegebenen Toleranzbereich der Soll-Frequenz des mindestens ersten Taktgebers (T1) mittels der Recheneinheit, und
- Ausgeben mindestens einer Zustandsinformation über den mindestens ersten Taktgeber (T1) anhand des Vergleichs mittels der Recheneinheit.

2. Verfahren nach Anspruch 1,
wobei als mindestens eine Zustandsinformation über den mindestens ersten Taktgeber (T1) eine Warnung ausgegeben wird, wenn die ermittelten Abweichungen und/oder der Durchschnittswert der ermittelten Abweichungen außerhalb des vorgegebenen Toleranzbereichs der Soll-Frequenz liegen.

3. Verfahren nach mindestens einem der Ansprüche 1-2,
wobei als mindestens eine Zustandsinformation über den mindestens ersten Taktgeber (T1) ein Korrekturfaktor ausgegeben wird, wobei der Korrekturfaktor angibt, in welchem Maß der mindestens erste Taktgeber (T1) von dem vorgegebenen Toleranzbereich abweicht.

4. Verfahren mindestens einem der Ansprüche 1-3,
wobei als mindestens eine Zustandsinformation über den mindestens ersten Taktgeber (T1) eine Restfunktionsdauer des mindestens ersten Taktgebers (T1) ausgegeben wird, nach deren Ablauf die ermittelten Abweichungen und/oder der Durchschnittswert der ermittelten Abweichungen außerhalb des vorgegebenen Toleranzbereichs liegen werden.

5. Verfahren nach mindestens einem der Ansprüche 1-4,
wobei die Ist-Frequenz des mindestens ersten Taktgebers (T1) mithilfe der ermittelten Abweichungen und/oder dem Durchschnittswert der ermittelten Abweichungen und/oder dem Korrekturfaktor auf die Soll-Frequenz korrigiert wird.

6. Verfahren nach mindestens einem der Ansprüche 1-5,
wobei das erste Feldgerät (F1) zumindest mittels des mindestens ersten Taktgebers (T1) mindestens einen chemischen und/oder physikalischen Parameter des Mediums bestimmt und/oder überwacht.

7. Verfahren nach mindestens einem der Ansprüche 1-6,
wobei jede ermittelte Abweichung in Abhängigkeit von dem Feldgerät (F2, F3), durch welches sie ermittelt wurde, gewichtet wird.

8. Verfahren nach mindestens einem der Ansprüche 1-6,
wobei jede ermittelte Abweichung in Abhängigkeit von einer Zustandsinformation des Feldgeräts (F2, F3), durch welches sie ermittelt wurde, gewichtet wird.

9. Verfahren nach Anspruch 8,
wobei als Zustandsinformation des Feldgeräts (F2, F3) ein Zeitraum seit der letzten Kalibration des Taktgebers (T2, T3) des jeweiligen Feldgeräts (F2, F3) und/oder das Vorliegen eines Fehlers und/oder eines Wartungsbedarfs des Feldgeräts (F2, F3) und/oder eine Genauigkeitsklasse des mindestens einen Taktgebers (T2, T3) des Feldgeräts (F2, F3) verwendet wird.

10. Verfahren nach mindestens einem der Ansprüche 1-9,
wobei als das erste Feldgerät (F1) ein Dichtemessgerät, ein Durchflussmessgerät oder ein Laufzeit-Füllstandsmessgerät verwendet wird.

## Claims

1. A method for checking at least one first clock generator (T1) of a first field device (F1) in a process measurement system (P),
wherein the process measurement system (P) comprises the first field device (F1) and at least two further field devices (F2, F3), each having at least one clock generator (T2, T3),
wherein each field device (F1, F2, F3) determines and/or monitors at least one chemical and/or physical parameter of a medium,
wherein a setpoint frequency is specified for each clock generator (T1, T2, T3) and each clock generator (T1, T2, T3) generates an actual frequency,
wherein the first field device (F1) comprises a computing unit and is configured to exchange information with the at least two further field devices (F2, F3),
wherein the method comprises at least the following steps:
• generating an actual frequency of the at least one first clock generator (T1),
• transmitting the generated actual frequency and the setpoint frequency of the at least one first clock generator (T1) to the at least two further field devices (F2, F3),
• determining a deviation of the generated actual frequency from the setpoint frequency of the at least one first clock generator (T1) by means of the respective clock generator (T2, T3) of the at least two further field devices (F2, F3),
• transmitting the determined deviations to the first field device (F1),
• comparing the determined deviations and/or an average value of the determined deviations with a predefined tolerance range of the setpoint frequency of the at least one first clock generator (T1) by means of the computing unit, and
• outputting at least one status information item relating to the at least one first clock generator (T1) on the basis of the comparison by means of the computing unit.

2. The method according to claim 1,
wherein as the at least one status information item for the at least one first clock generator (T1), a warning is output if the determined deviations and/or the average value of the determined deviations lie outside the predefined tolerance range of the setpoint frequency.

3. The method according to at least one of claims 1-2,
wherein as the at least one status information item for the at least one first clock generator (T1), a correction factor is output,
wherein the correction factor indicates the extent to which the at least one first clock generator (T1) deviates from the predefined tolerance range.

4. The method according to at least one of claims 1-3,
wherein as the at least one status information item for the at least one first clock generator (T1), a remaining service life of the at least one first clock generator (T1) is output,
after the expiry of which the determined deviations and/or the average value of the determined deviations will lie outside the predefined tolerance range.

5. The method according to at least one of claims 1-4,
wherein the actual frequency of the at least one first clock generator (T1) is corrected to the setpoint frequency using the determined deviations and/or the average value of the determined deviations and/or the correction factor.

6. The method according to at least one of claims 1-5,
wherein the first field device (F1) determines and/or monitors at least one chemical and/or physical parameter of the medium at least by means of the at least one first clock generator (T1).

7. The method according to at least one of claims 1-6,
wherein each determined deviation is weighted as a function of the field device (F2, F3) by which it was determined.

8. The method according to at least one of claims 1-6,
wherein each determined deviation is weighted as a function of a status information item of the field device (F2, F3) by which it was determined.

9. The method according to claim 8,
wherein as the status information item of the field device (F2, F3),
a period since the last calibration of the clock generator (T2, T3) of the respective field device (F2, F3),
and/or the presence of a fault and/or a maintenance requirement of the field device (F2, F3), and/or an accuracy class of the at least one clock generator (T2, T3) of the field device (F2, F3) is used.

10. The method according to at least one of claims 1-9,
wherein the first field device (F1) is a density measuring device, a flow measuring device, or a time-of-flight level measuring device.

## Revendications

1. Procédé de vérification d'au moins un premier générateur d'horloge (T1) d'un premier appareil de terrain (F1) dans un système de mesure de procédé (P),
le système de mesure de procédé (P) comprenant le premier appareil de terrain (F1) et au moins deux autres appareils de terrain (F2, F3), chacun comprenant au moins un générateur d'horloge (T2, T3),
chaque appareil de terrain (F1, F2, F3) déterminant et/ou surveillant au moins un paramètre chimique et/ou physique d'un fluide,
une fréquence de consigne étant définie pour chaque générateur d'horloge (T1, T2, T3) et chaque générateur d'horloge (T1, T2, T3) générant une fréquence réelle,
le premier appareil de terrain (F1) comprenant une unité de calcul et étant configuré pour échanger des informations avec les au moins deux autres appareils de terrain (F2, F3),
le procédé comprenant au moins les étapes suivantes :
• génération d'une fréquence réelle du au moins un premier générateur d'horloge (T1),
• transmission de la fréquence réelle générée et de la fréquence de consigne du au moins un premier générateur d'horloge (T1) aux au moins deux autres appareils de terrain (F2, F3),
• détermination d'un écart entre la fréquence réelle générée et la fréquence de consigne du au moins un premier générateur d'horloge (T1) au moyen du générateur d'horloge respectif (T2, T3) des au moins deux autres appareils de terrain (F2, F3),
• transmission des écarts déterminés au premier appareil de terrain (F1),
• comparaison des écarts déterminés et/ou d'une valeur moyenne des écarts déterminés avec une plage de tolérance prédéfinie de la fréquence de consigne du au moins un premier générateur d'horloge (T1) au moyen de l'unité de calcul, et
• émission d'au moins une information d'état concernant le au moins un premier générateur d'horloge (T1) sur la base de la comparaison au moyen de l'unité de calcul.

2. Procédé selon la revendication 1,
dans lequel, en tant qu'au moins une information d'état relative au au moins un premier générateur d'horloge (T1), une alerte est émise lorsque les écarts déterminés et/ou la valeur moyenne des écarts déterminés se situent en dehors de la plage de tolérance prédéfinie de la fréquence de consigne.

3. Procédé selon l'une quelconque des revendications 1 à 2,
dans lequel, en tant qu'au moins une information d'état relative au au moins un premier générateur d'horloge (T1), un facteur de correction est émis,
le facteur de correction indiquant la mesure dans laquelle le au moins un premier générateur d'horloge (T1) s'écarte de la plage de tolérance prédéfinie.

4. Procédé selon l'une quelconque des revendications 1 à 3,
dans lequel, en tant qu'au moins une information d'état relative au au moins un premier générateur d'horloge (T1), une durée de vie résiduelle du au moins un premier générateur d'horloge (T1) est émise,
après l'expiration de laquelle les écarts déterminés et/ou la valeur moyenne des écarts déterminés se situeront en dehors de la plage de tolérance prédéfinie.

5. Procédé selon l'une quelconque des revendications 1 à 4,
dans lequel la fréquence réelle du au moins un premier générateur d'horloge (T1) est corrigée vers la fréquence de consigne à l'aide des écarts déterminés et/ou de la valeur moyenne des écarts déterminés et/ou du facteur de correction.

6. Procédé selon l'une quelconque des revendications 1 à 5,
dans lequel le premier appareil de terrain (F1) détermine et/ou surveille au moins un paramètre chimique et/ou physique du fluide au moins au moyen du au moins un premier générateur d'horloge (T1).

7. Procédé selon l'une quelconque des revendications 1 à 6,
dans lequel chaque écart déterminé est pondéré en fonction de l'appareil de terrain (F2, F3) par lequel il a été déterminé.

8. Procédé selon l'une quelconque des revendications 1 à 6,
dans lequel chaque écart déterminé est pondéré en fonction d'une information d'état de l'appareil de terrain (F2, F3) par lequel il a été déterminé.

9. Procédé selon la revendication 8,
dans lequel, en tant qu'information d'état de l'appareil de terrain (F2, F3),
une durée écoulée depuis la dernière calibration du générateur d'horloge (T2, T3) de l'appareil de terrain respectif (F2, F3),
et/ou la présence d'un défaut et/ou d'un besoin de maintenance de l'appareil de terrain (F2, F3), et/ou une classe de précision du au moins un générateur d'horloge (T2, T3) de l'appareil de terrain (F2, F3) est utilisée.

10. Procédé selon l'une quelconque des revendications 1 à 9,
dans lequel le premier appareil de terrain (F1) est un densimètre, un débitmètre ou un appareil de mesure de niveau par temps de propagation.
